# EUROPEAN PATENT SPECIFICATION

(11) **EP 2 127 076 B1**
(45) Date of publication and mention of the grant of the patent: **18.07.2012**
(21) Application number: 08702466.7
(22) Date of filing: 18.01.2008
(51) Int. Cl.: H03J 7/04

(54) **AN AUTOMATIC RADIO TUNING SYSTEM**
AUTOMATISCHES FUNKABSTIMMSYSTEM
SYSTÈME DE RÉGLAGE AUTOMATIQUE DE RADIO

(30) Priority: 22.01.2007 EP 07100946
(43) Date of publication of application: 02.12.2009
(73) Proprietor: NXP B.V., 5656 AG Eindhoven (NL)
(72) Inventor: BRUMMELMAN, Wim-Jan, Redhill Surrey RH1 5HA (GB)
(74) Representative: Williamson, Paul Lewis
(86) International application number: PCT/IB2008/050190
(87) International publication number: WO 2008/090503

(56) References cited:
- EP-A- 0 447 237
- JP-A- 60 233 923
- US-A- 3 902 122
- US-A- 4 009 442
- US-A- 4 020 421

## Description

The invention relates to an automatic radio tuning system, and in particular to a low cost automatic radio tuner for receiving radio transmissions related to specific events.

So-called "event radio" is the broadcasting of audio information that is specifically related to a particular event, for example a music concert, or a sporting event. UK Patent Application GB 2381397 discloses a radio receiver specifically designed for an event, and further discloses broadcasting audio information on a particular frequency, and providing members of the audience of the event with radio receivers that are tuned to that particular frequency.

EP 0447237 describes that in a tone-in-band (TIB) single-sideband-modulated communication system used to communicate digital data in order to compensate for variations due, eg, to doppler shift of the pilot tone in the received signal, during the sweep of the frequency of a local oscillator used to tune the receiver, the output of a narrow band filter is monitored for the presence of the expected pilot tone. When the pilot tone appears to be present the sweep is interrupted and the error rate of the demodulated digital signal is tested, the sweep being resumed if an excessive error rate is encountered. In order to counter misreception due to co-channel interference, the pilot tone is offset by a small but detectable amount from that used in a co-channel transmission in preparing the TIB transmission either by using a different frequency split-point or by producing the signal in a slightly different part of the channel.

However, the radio frequencies which are available for use in event radio are likely to vary according to the geographical location of the event, for example due to interference with other radio stations.

Furthermore, the radio frequency to be used at an event may not be known at the time of the manufacture of the radio receivers, and the radio receivers may each have to be manually tuned to the event radio frequency before they can be usefully distributed to an audience.

It is therefore an object of the invention to improve upon the known art.

According to a first aspect of the invention, there is provided a method for tuning a radio receiver to a radio signal that comprises an audio signal, the audio signal having an embedded identification signal; the method comprising:
a) tuning the radio receiver to a first radio signal;
b) testing the first radio signal for the identification signal; and
c) automatically repeating steps a) and b) for subsequent radio signals until the radio receiver is tuned to the radio signal having the identification signal.

Hence, the radio receiver may automatically tune itself to the radio frequency being used for the event radio, by searching for a radio signal having the identification signal within the audio signal of the radio signal. Therefore, the radio receiver does not need to be tuned to a particular frequency before it is distributed to the audience, and can automatically tune itself to whatever frequency is in use at the particular event.

The radio receiver may filter the received audio signal to remove the identification signal from the audio signal before playback. Hence, any audible effects of the identification signal may be reduced or removed.

Embedding the identification signal within the audio signal, instead of using a digital system such as RDS, enables a physically small and very low cost solution. This is because the received radio signal can be demodulated using a very simple and small demodulator, and the identification signal within the audio signal can be detected without the need for any complex RDS circuitry. These advantages are particularly important for event radio receivers, which should be easy for members of the audience to handle, and inexpensive enough to encourage members of the audience to acquire them.

Furthermore, the identification signal may be of an audible amplitude, and hence the received audio signal may become unpleasant, annoying, or distracting to listen to unless the identification signal is removed from the audio signal before playback. Therefore, the organisers of an event may be able to provide exclusive listening to the listeners who posses an event radio that is capable of removing the identification signal from the received audio signal before playback.

The audio signal may comprise a monaural signal component and a stereo signal component, and the stereo signal component may comprise the identification signal. The radio receiver may only play the monaural component of the audio signal, thereby removing the identification signal cheaply and automatically. Furthermore, the stereo signal component may further comprise audio data in addition to the identification signal, and the audio data may be designed to be unpleasant, distracting, or annoying to listeners who do not have a radio receiver suitable for playing only the monaural audio signal. This helps to provide exclusive listening to those listeners who are in possession of an event radio receiver.

The frequency of the transmitted radio signal may be regularly altered between at least two different frequencies, and in response to this the radio receiver may automatically re-tune itself to follow the changing frequency of the radio signal. Hence, radio receivers that cannot recognise the identification signal may regularly require manual re-tuning in order to continue receiving the event radio, thereby helping to provide exclusive listening to those listeners having a radio receiver that can recognise the identification signal.

The radio receiver may be adjustable to automatically tune to a radio signal that comprises a further identification signal. Hence, the radio receiver may be switched between different event radio broadcasts.

The adjusting may comprise adjusting the radio receiver to tune to a radio signal that comprises an audio signal having a particular identification signal. For example, the amplitude of an identification signal may be modulated to carry information identifying the audio signal, and the radio receiver may be adjusted to automatically tune to a radio signal that has an identification signal which is modulated with this particular information. Alternatively, different event radio broadcasts may be associated with different frequency identification signals, and the radio receiver may be adjusted to automatically tune to a radio signal having an identification signal of a particular frequency.

The adjustment may be under the control of the listener to provide the listener with a choice, or it may be under the control of the event organiser. The event organiser may wirelessly communicate to the listener's radio receiver a description of the identification signals of the event radio broadcasts that the listener is entitled to receive. This could be achieved, for example, by using Near Field Communication (NFC), as will be apparent to those skilled in the art.

Further aspects of the invention are provided as laid out in the appended set of claims. Further features of the invention will become apparent from the following description, by way of example only, and with reference to the accompanying drawings, in which:
Fig.1 shows a block diagram of an automatic radio tuning system according to first embodiment of the invention;
Fig.2a shows a spectral diagram of an MPX radio signal as is known in the art;
Fig.2b shows a block diagram of a known radio receiver for receiving the MPX signal of Fig.2a;
Fig.3a shows a spectral diagram of an MPX radio signal according to a second embodiment of the invention;
Fig.3b shows a block diagram of a radio receiver according to the second embodiment for receiving the MPX signal of Fig.3a;
Fig.4 shows a flow diagram of the automatic tuning of the radio receiver of Fig.3a according to the second embodiment;
Fig.5 shows a block diagram of a transmitter according to the second embodiment;
Fig.6a, 6b and 6c depict a third embodiment of the invention;
Fig. 7 shows a radio receiver according to the third embodiment incorporated within a radio.

The figures are not drawn to scale. Same or similar reference signs denote same or similar features.

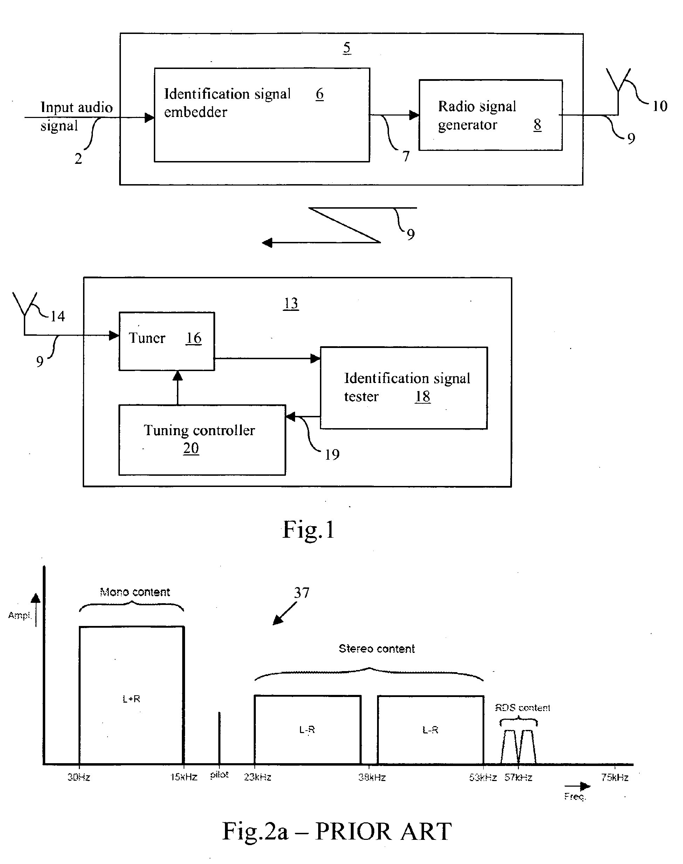

The basic principles of the automatic radio tuning system will now be described with reference to the first embodiment shown in Fig. 1. The automatic radio tuning system comprises a transmitter 5 for transmitting a radio signal 9 that comprises an audio signal 7 having an embedded identification signal. The identification signal is typically a continuous signal, rather than an intermittent signal, since a radio receiver should be able to tune to a radio signal and quickly determine whether or not the radio signal has an identification signal.

The identification signal is embedded into an input audio signal 2 using an identification signal embedder 6, and then the output radio signal 9 is generated from the audio signal 7 using a radio signal generator 8. The radio signal 9 is broadcast by antenna 10.

Those skilled in the art will appreciate the diversity of the components that may be used to implement the identification signal embedder and the radio signal generator. For example, the identification signal may be a single tone having a fixed frequency and amplitude, or it may be modulated to carry information or to make it unpleasant to listen to (thereby helping to provide exclusive listening to the listeners who have a radio receiver capable of filtering out the identification signal before playback). Furthermore, many different modulation schemes for combining the input audio signal 2 and identification signal into the audio signal 7 and into the radio signal 9 may easily be conceived.

The automatic radio tuning system further comprises a radio receiver 13 for receiving the radio signal 9 via an antenna 14. The radio receiver 13 comprises a tuner 16 for tuning to the radio signal 9, an identification signal tester 18 for testing (determining, recognising, or monitoring) whether the received radio signal comprises the identification signal, and a tuning controller for controlling the radio frequency to which the tuner 16 is tuned.

In use, the tuner 16 receives a radio signal via the antenna 14, the identification signal tester 18 tests the radio signal for the identification signal, and passes a signal 19 to the tuning controller 20 that indicates whether the identification signal is present or not. If the signal 19 indicates that the identification signal is present, then the tuning controller 20 maintains the frequency to which the tuner 16 is tuned. If the signal 19 indicates that the identification signal is not present, then the tuning controller 20 changes the frequency to which the tuner 16 is tuned in order to receive another radio signal. Hence, the tuner 16 is tuned through subsequent radio signals, until the radio signal 9 having the identification signal is received.

Those skilled in the art will appreciate the diversity of the components that may be used to implement the tuner, identification signal tester, and the tuning controller. These are likely to vary according to the modulation schemes that are used at the radio transmitter, according to the form of the identification signal that is embedded within the audio signal, and according to the audio output that is required (e.g. monaural or stereo, high or low audio quality).

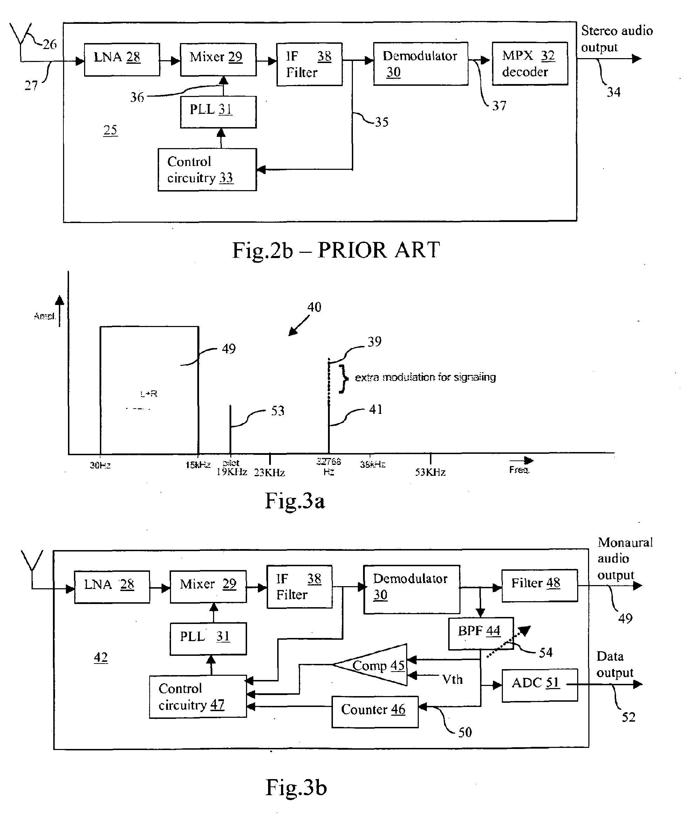

In order to place the second embodiment of the invention in context, the reader is first presented with the following discussion of a well-known prior art radio system in relation to Figures 2a and 2b.

Fig.2a shows a spectral diagram of a typical multiplex (MPX) format signal 37, as is well-known in the art. The signal 37 comprises an audio signal comprising a monaural audio component extending from 30 Hz - 15 kHz, and a stereo audio component centred on 38 kHz and extending from 23 kHz to 53 kHz. The MXP signal further comprises a pilot signal at 19 KHz which indicates that a stereo audio component is present, and RDS content centred at 57 kHz. The MPX signal is typically modulated onto an RF carrier, giving an FM radio signal, and then broadcast.

The frequency of the FM radio signal depends on the radio channel which is used for the broadcast, as will be apparent to those skilled in the art.

Fig.2b shows a block diagram of a well-known radio receiver 25 for receiving an FM radio signal 27 comprising the MPX signal 37 of Fig.2a. The radio receiver 25 comprises a low noise amplifier (LNA) 28 for amplifying the radio signal 27 received by the antenna 26. The output of the LNA 28 is connected to a mixer 29 and an Intermediate Frequency (IF) filter 38 for down-converting the radio signal 27 to an intermediate frequency signal 35. The output of the IF filter 38 is connected to a demodulator 30 for demodulating the intermediate frequency signal 35, and to a control circuitry 33 for controlling a phase lock loop (PLL) 31 to generate the signal 36 that is used for down-converting the radio signal 27.

The demodulated signal that is output from the demodulator 30 is the MPX signal 37 of Fig.2a. The MPX signal 37 is decoded using an MPX decoder to give left and right stereo audio output signal 34. The MPX decoder uses the 19 kHz pilot signal to generate a 38 kHz signal for demodulating and outputting the left and right audio signals from the MPX signal's monaural and stereo audio components.

In use, the control circuitry 33 first sets the PLL 31 to a frequency corresponding to a particular radio channel, and then the control circuitry checks if there is a radio signal present at that channel. If there is a radio signal present, the PLL remains at that channel. If there is no radio signal at that particular channel, then the PLL is set to another frequency corresponding to another radio channel, and so on until the control circuitry detects a valid radio signal, as will be apparent to those skilled in the art. The second embodiment of the invention will now be described in relation to Figures 3a - 5. Fig. 3a shows a spectral diagram of an MPX signal 40, which comprises a monaural audio component extending from 30 Hz to 15 kHz, and a stereo audio component extending from 23 kHz to 53 kHz, in accordance with the standard MPX signal format. The monaural audio component comprises audio data 49, and the stereo audio component comprises a fixed tone identification signal 41 of 32.768 kHz. The amplitude of the fixed tone identification signal 41 is modulated 39 to carry information for identifying the audio of the MPX signal 40 to the receiver. The MPX signal 40 further comprises a pilot signal 53 at 19 kHz indicating that stereo audio content is present. The MPX signal 40 is modulated onto a radio signal, and the radio signal's frequency is periodically stepped between different FM radio channels.

If the known radio receiver of Fig. 2a is used to receive a radio signal comprising the MPX signal 40, then the pilot signal 53 indicates to the known receiver that stereo audio content is present. Hence, the 32.768 kHz identification signal within the stereo audio component is demodulated to give a 5.232 kHz audio output tone superimposed on the monaural content, which can be unpleasant to listen to, and which is likely to discourage people having conventional stereo radio receivers from listening to the event radio broadcast. Furthermore, since the radio signal frequency steps between radio channels, in order to continue to receive the MPX signal 40, the radio receiver of Fig.2a would have to be periodically re-tuned to follow the changing radio frequency. This also helps to discourage people from using a conventional stereo radio receiver to listen to the event radio broadcast.

Figure 3b shows a block diagram of a radio receiver 42 according to the second embodiment of the invention, and for receiving a radio signal comprising the MPX signal 40 of Fig.3a.

The radio receiver 42 comprises an LNA 28, a mixer 29, an IF filter 38, a PLL 31, and a demodulator 30 in common with the conventional radio receiver of Fig.2a, and the radio receiver 42 further comprises a band pass filter (BPF) 44, a comparator 45, a frequency counter 46, a control circuitry 47, an output filter 48, and an Analogue to Digital Converter (ADC) 51.

The BPF 44 is set at 32.768 kHz, such that only signal 50 having frequencies close to 32.768 kHz is passed to the comparator 45 and the frequency counter 46. The comparator 45 compares the amplitude of the signal 50 to a threshold voltage Vth, and sends the result of the comparison to the control circuitry 47. The frequency counter 46 counts the number of cycles of signal 50 in a given period of time, and sends the count number to the control circuitry 47. The count number represents the frequency of the signal 50. The ADC 51 converts the amplitude of the signal 50 into digital output data 52.

The output filter 48 filters out all the frequencies of the MPX signal 40 that are above 15 kHz, including the 19 kHz pilot signal and any 32.768 kHz identification signal that may be present, leaving the monaural audio component for playback.

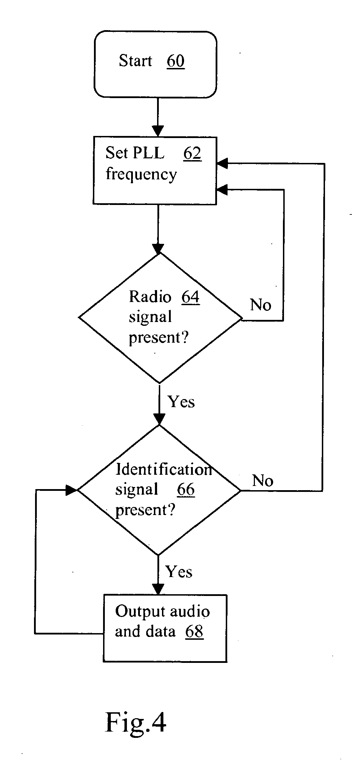

The automatic tuning of the radio receiver 42 of Fig.3b to a radio signal comprising the MPX signal 40 of Fig.3a will now be described with reference to the flow diagram of Fig.4.

When the radio receiver is powered on at step 60, the control circuitry 47 tunes to a radio channel at step 62 by setting its PLL 31. Next, at step 64, the control circuitry 47 determines whether or not a radio signal is being received, and if not, then the PLL 31 is set by the control circuitry 47 to tune to a further radio channel at step 62. Steps 62 and 64 are repeated until the receiver is tuned to a valid radio signal.

The received radio signal is demodulated by the demodulator 30, and at step 66 is tested for the 32.768 kHz identification signal 41. The testing comprises passing the demodulated radio signal through the 32.768 kHz band pass filter (BPF) 44, and testing the amplitude (using the comparator 45) and frequency (using the frequency counter 46) of the filter's output. If the identification signal is present, then a large amplitude signal at 32.768 kHz will be detected. The requirement for a large amplitude signal at 32.768 kHz means that is it very unlikely that normal audio content would falsely be detected as having an identification signal. The results of the amplitude and frequency tests are communicated to control circuitry 47.

If the identification signal is not present, then the received radio signal does not comprise the MPX signal 40 of Fig.3a, and so the control circuitry 47 sets the PLL 31 to another radio channel to search for another radio signal at step 62. If the identification signal is present, then this signals to the control circuitry 47 that the radio receiver is correctly tuned to the radio signal having the MPX signal 40. Then, at step 68 the demodulated radio signal is filtered by the output filter 48, outputting the monaural audio data 49 for playback. The amplitude modulation 39 of the identification signal 41 is digitised by the analogue to digital converter 51, and output as digital data 52. The digital data 52 carries information identifying the audio signal of the MPX signal 40.

The received radio signal is repeatedly tested for the identification signal 41, so that the receiver will loop back to step 62 and re-start the search for the identification signal if the identification signal of the received radio signal disappears. Hence, the radio receiver can automatically re-tune itself to follow the MPX signal 40 when the MPX signal 40 is modulated onto a radio signal which periodically changes frequency (i.e. changes radio channel).

The BPF 44 has a fixed frequency of 32.768 kHZ for detecting 32.768 kHz identification signals, although the BPF 44 could be adjusted 54 for detecting different frequency identification signals. For example, an event radio broadcaster may broadcast two event radio signals, one having an identification signal frequency of 32.768 kHz, and one having an identification signal frequency of 34 kHz. The radio receiver could be switched between the two event radio broadcast signals by adjusting 54 the BPF 44 to pass frequencies of 32.768 or 34 kHz, and by adjusting the control circuitry 47 to look for 32.768 or 34 kHz from the frequency counter 46. The radio receiver could be adjusted 54 by the user, for example by switching a switch, or it could be adjusted 54 by the organiser of the event, for example by switching a switch, or by using wireless near field communication (NFC). Alternatively, instead of using two different identification signal frequencies for two different event radio broadcasts, the identification signal frequencies of each broadcast could be the same, and the amplitude of the identification signals could each be modulated 39 with different data. For example, the first event radio broadcast could have a 32.768 kHz identification signal amplitude modulated to give output data 52 that repeated the bit-pattern "0101 ", and the second event radio broadcast could have a 32.768 kHz identification signal amplitude modulated to give output data 52 that repeated the bit-pattern "0111". Then, the radio receiver could be adjusted to look for a particular identification signal having one or the other of the two bit patterns. Those skilled in the art will appreciate that this scheme could be combined with the adjustable BPF 44 scheme to allow for adjustment between four event radio broadcast signals. Furthermore, multiple different identification signal frequencies and multiple different identification signal bit-patterns could be used. Again, the adjustment could be performed by the user, for example by switching a switch, or it could be performed by the organiser of the event, for example by switching a switch, or by using wireless near field communication (NFC).

The event radio broadcaster could simply broadcast multiple event radio signals, all having the same identification signal, and allow the listener to cycle through the different broadcasts. This could be done by providing a button on the event radio that is linked to control circuitry 47, such that a listener could press the button to make the radio receiver move from step 68 back to step 62.

This embodiment may be extended by including further audio data within the stereo signal component, in addition to the identification signal audio data. This further audio data is designed to sound unpleasant, annoying, or distracting to listeners who attempt to listen to the event radio broadcast in stereo, thereby helping to give exclusive listening to listeners in possession of an event radio. The further audio data may for example comprise fixed tone audio frequencies of large amplitudes.

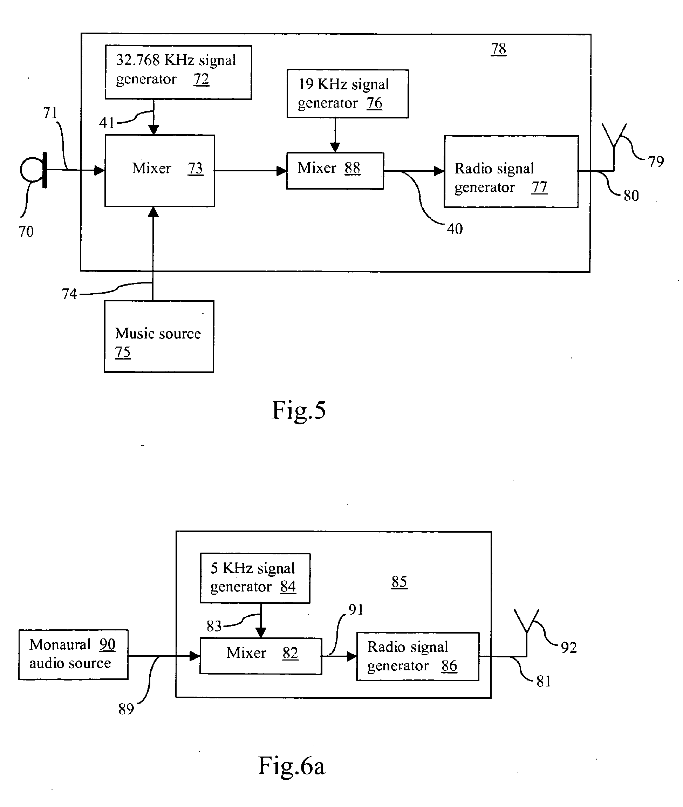

Fig.5 shows a block diagram of a transmitter 78 according to the second embodiment. The transmitter 78 transmits a radio signal 80 comprising the MPX signal 40 of Fig.3a, via the antenna 79.

The transmitter 78 comprises a 32.768 kHz signal generator 72 for generating the identification signal 41, a 19 kHz signal generator for generating the pilot signal 53, two mixers 73 and 75, and a radio signal generator 77. The mixer 73 is supplied with the identification signal 41, a monaural audio signal 74 from a music source such as a CD player, and an audio signal 71 from a microphone 70. The mixer 73 mixes these signals together, and outputs them to the mixer 88, where they are added to the 19 KHz signal from the signal generator to form the MPX signal 40. The MPX signal 40 is then modulated onto a radio signal by the radio signal generator 77, giving the radio signal 80. The radio signal 80 is broadcast using the antenna 79.

The identification signal generator 72 modulates 39 the amplitude of the identification signal to send a repeating bit sequence "0101 ", and the radio signal generator 77 periodically changes the frequency of the radio signal 80 between different radio channels.

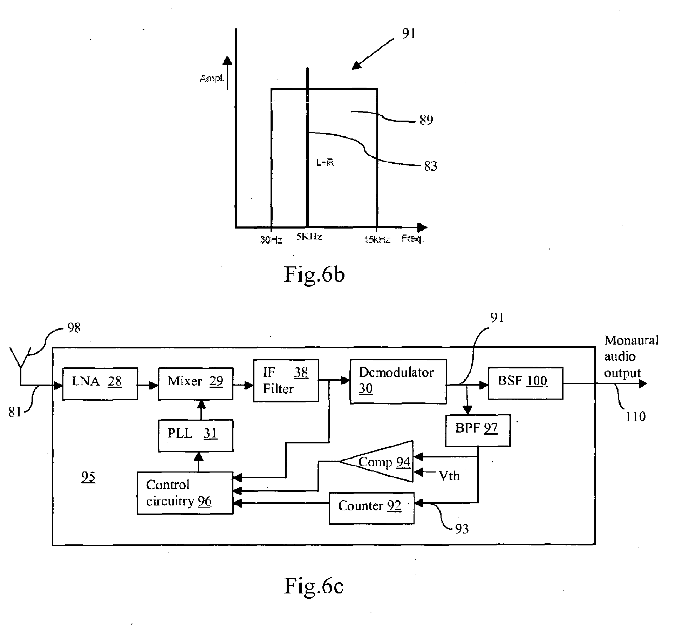

A third embodiment of the invention will now be described with reference to Figs. 6a, 6b, and 6c.

The transmitter 85 of Fig.6a comprises a mixer 82 for mixing together an identification signal 83 and a monaural audio signal 89. The identification signal 83 is a continuous 5 kHz signal that is generated by a k KHz signal generator 84. The monaural audio signal 89 is received from a monaural audio source 90, for example a microphone.

The mixer outputs signal 91, and the frequency spectrum of signal 91 is shown in Fig.6b. As can be seen from Fig.6b, the signal 91 comprises the monaural audio signal 89 extending from 30-15 kHz, and the identification signal 83 at k KHz. The amplitude of the identification signal 83 is comparable to that of the monaural audio signal 89, such that a listener listening to signal 91 would easily hear the identification signal and may find this unpleasant.

The signal 91 is modulated onto a radio signal 81 by a radio signal generator 86, and the signal 81 is broadcast via an antenna 92. The radio signal generator 86 typically uses Frequency (FM) or Amplitude (AM) modulation, the implementation details of which will be apparent to those skilled in the art.

Fig. 6c shows a block diagram of a radio receiver 95 according to the third embodiment, which is receiving the radio signal 81 via an antenna 98. The radio signal 81 is demodulated by the demodulator 30 to give the signal 91, the frequency spectrum of which is shown in Fig. 6b.

The signal 91 is input to a band stop filter (BSF) 100, which is also set at 5 kHz. The filter 100 passes nearly all of the monaural audio signal 89 that extends from 30 Hz-15 kHz, but blocks the identification signal 83 at 5 kHz. Hence, the monaural audio output signal 110 that is output from the filter 100 is almost the same as the monaural audio signal 89, except that a few frequencies close to k KHz are missing. The range of the frequencies that are missing will depend on the bandwidth of the band stop filter. Ideally the bandwidth will be narrow, so that a minimal range of frequencies are missing and so that there is a minimal impact on the monaural signal 89, as will be apparent to those skilled in the art.

The signal 91 is also input to a band pass filter (BPF) 97, which is set at k KHz. Hence, the filter's output signal 93 comprises the k KHz identification signal 83, and may also comprise frequencies of the monaural audio signal 89 that are close to 5 KHz. A comparator 94 indicates to control circuitry 96 that the signal 93 has an amplitude greater than Vth (due to the identification signal 83), and a frequency counter 92 indicates to the control circuitry 96 that the signal 93 has a frequency of 5 kHz (due to the identification signal 83). Hence, the control circuitry 96 determines that the identification signal is present, and that the PLL 31 is tuned to the correct frequency.

If, for example, the radio signal generator 86 of transmitter 85 changes the radio signal frequency, (as may be done to force listeners who are not using a radio that can follow the identification signal to manually re-tune their radios to the new frequency), then the amplitude of signal 91 will drop, and the frequency of signal 91 is likely to vary from 5 kHz, since the 5 kHz identification signal 83 will no longer be received. Hence, the output of the comparator 94 will indicate to the control circuitry 96 that the amplitude has fallen below Vth, and the output of the frequency counter 92 is likely to indicate to the control circuitry 96 that the frequency is no longer 5 kHz. The control circuitry 96 will then automatically set the PLL 31 to subsequent radio channels until the radio is re-tuned to the new radio frequency that has the radio signal 81 comprising the identification signal 83.

The actual value of the voltage level Vth will depend on the amplitude of the identification signal compared to the amplitude of the monaural audio signal. The voltage level Vth must be must be high enough so that the amplitude of audio data does not normally rise above it and indicate that an identification signal is present when there is none, but low enough so that the amplitude of a received identification signal rises above it and indicates that the identification signal is present. The control circuitry 47 may include an averaging circuit that outputs the average value of the output of the comparator 94, so that audio data that temporarily has 5 kHz frequency components above the voltage Vth will not result in false indications of the identification signal.

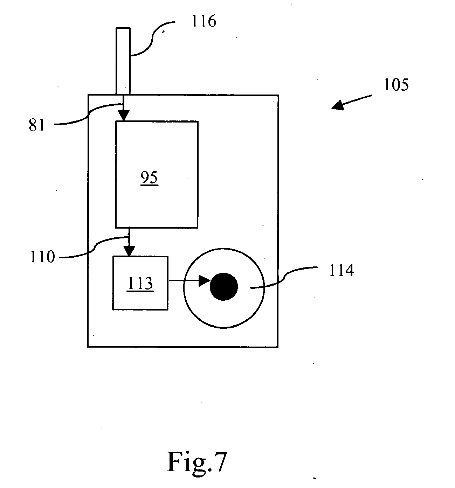

The radio receiver of the first, second or third embodiments can be incorporated into an event radio for receiving the radio signal 81 and for playing the monaural audio output 110. For example, Fig. 7 shows the radio receiver 95 of the third embodiment incorporated within a radio 105. The radio receiver 95 receives the radio signal 81 via the antenna 116, and then outputs monaural audio 110 to a power amplifier 113. The power amplifier 113 drives the speaker 114, thereby playing the monaural audio 89.

In summary, the invention relates to a system for automatically tuning a radio receiver to a radio broadcast. The system comprises a radio transmitter for transmitting a radio signal that has an identification signal within an audio signal of the radio signal. The radio receiver automatically tunes itself through multiple radio channels until the radio signal having the identification signal is found. Since the identification signal is within the audio signal, radio receivers that are not capable of removing the identification signal will playback the identification signal, which the listener may find unpleasant, and which provides exclusive listening to listeners who have a radio receiver that is capable of removing the identification signal.

From reading the present disclosure, other variations and modifications will be apparent to the skilled person. Such variations and modifications may involve equivalent and other features which are already known in the art of radio systems, and which may be used instead of, or in addition to, features already described herein. For example, although the embodiments herein have concentrated on event radio receivers that only playback monaural audio, other embodiments where the event radio receiver plays back stereo audio may easily be conceived by those skilled in the art. The identification signal may be in either or both of the monaural or stereo components of the audio signal. Furthermore, the absolute values of the signal frequencies quoted herein are purely by way of non-limiting example only.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, and reference signs in the claims shall not be construed as limiting the scope of the claims.

## Claims

1. A method for tuning a radio receiver (13; 42; 95) to a radio signal (9; 80; 81) that comprises an audio signal (7; 91), the audio signal having an embedded identification signal (41; 83) the method comprising:
a) tuning (62, 64) the radio receiver to a first radio signal;
b) testing (66) the first radio signal for the identification signal; and
c) automatically repeating steps a) and b) for subsequent radio signals until the radio receiver is tuned to the radio signal having the identification signal.

2. The method of claim 1, further comprising filtering (48; 100) the audio signal at the radio receiver to remove the identification signal (41; 83), and playing the filtered audio signal.

3. The method of claims 1 or 2, wherein the audio signal comprises a monaural signal component and a stereo signal component, and wherein the stereo signal component comprises the identification signal (41).

4. The method of claim 3, wherein the method comprises filtering out the stereo audio component and playing only the monaural signal component.

5. The method of claim 4, wherein the stereo signal component comprises audio data in addition to the identification signal.

6. The method of any of claims 3 to 5, wherein the audio signal is comprised within an MPX format signal (40) of the radio signal, the MPX format signal further comprising a pilot signal (53) for indicating that stereo audio content is present.

7. The method of any of claims 1 to 6, wherein the identification signal is of an audible amplitude.

8. The method of any of claims 1 to 7, wherein the identification signal is a fixed tone signal (41, 83).

9. The method of any of claims 1 to 8, wherein, in response to an alteration of the frequency of the radio signal (80; 81), the steps a), b), and c) are repeated to re-tune the radio receiver to the altered frequency.

10. The method of any of claims 1 to 9, further comprising adjusting (54) the radio receiver to repeat the steps a), b), and c) to automatically tune to a radio signal that comprises an audio signal having a further identification signal.

11. The method of claim 10, wherein the adjusting comprises adjusting the radio receiver to tune to a radio signal that comprises an audio signal having a particular further identification signal.

12. The method of any of claims 1 to 11, wherein the amplitude of the identification signal (41) is modulated (39) to carry information identifying the audio signal.

13. A radio receiver (13; 42; 95) for tuning to a radio signal (9; 80; 81) that comprises an audio signal (7; 91), the audio signal having an embedded identification signal (41; 83); the radio receiver comprising:
- a tuner (16; 29, 31, 47), for tuning to a first radio signal;
- an identification signal tester (18; 44, 45, 46) for testing the first radio signal for the identification signal; and
- a tuning controller (20; 47) for automatically tuning the tuner to subsequent radio signals until the identification signal tester indicates that the tuner is tuned to the radio signal that has the identification signal.

14. A radio (105) comprising the radio receiver (13; 42; 95) of claim 13.

15. A transmitter (78; 85) adapted to transmit a radio signal (80; 81) comprising the audio signal (49; 89) and embedded identification signal (41; 83) of any of claims 1 to 12, the transmitter comprising:
- an identification signal embedder (73; 82) for embedding the identification signal within the audio signal;
- a radio signal generator (77; 86) for generating the radio signal comprising the audio signal with the embedded identification signal.

16. Apparatus for transmitting a radio signal and tuning to the radio signal, the apparatus comprising the transmitter of claim 15 and the radio receiver of claim 13.

17. A method for transmitting and tuning to a radio signal (9; 80; 81), the method comprising:
- embedding an identification signal (41; 83) within an audio signal (49; 89);
- transmitting a radio signal (9; 80; 81) that comprises the audio signal and the embedded identification signal;
- tuning a radio receiver (13; 42; 95) to the radio signal by:
a) tuning (62, 64) the radio receiver to a first radio signal;
b) testing (66) the first radio signal for the identification signal;
c) automatically repeating steps a) and b) for subsequent radio signals until the radio receiver is tuned to the radio signal having the identification signal.

## Patentansprüche

1. Ein Verfahren zum Tunen eines Funkempfängers (13; 42; 95) auf ein Funksignal (9; 80; 81), welches ein Audiosignal (7; 91) aufweist, wobei das Audiosignal ein eingebettetes Identifikationssignal (41; 83) hat, wobei das Verfahren aufweist:
a) Tunen (62; 64) des Funkempfängers auf ein erstes Funksignal;
b) Testen (66) des ersten Funksignals auf das Identifikationssignal; und
c) automatisches Wiederholen der Schritte a) und b) für nachfolgende Funksignale bis der Funkempfänger auf das Funksignal getunt ist, welches das Identifikationssignal hat.

2. Das Verfahren gemäß Anspruch 1, ferner aufweisend ein Filtern (48; 100) des Audiosignals an dem Funkempfänger, um das Identifikationssignal (41; 83) zu entfernen, und ein Spielen des gefilterten Audiosignals.

3. Das Verfahren gemäß Anspruch 1 oder 2, wobei das Audiosignal eine monaurale Signalkomponente und eine Stereosignalkomponente aufweist, und wobei die Stereosignalkomponente das Identifikationssignal (41) aufweist.

4. Das Verfahren gemäß Anspruch 3, wobei das Verfahren ein Herausfiltern der Stereoaudiokomponente und ein Spielen nur der monauralen Signalkomponente aufweist.

5. Das Verfahren gemäß Anspruch 4, wobei die Stereosignalkomponente Audiodaten zusätzlich zu dem Identifikationssignal aufweist.

6. Das Verfahren gemäß irgendeinem der Ansprüche 3 bis 5, wobei das Audiosignal innerhalb eines MPX Formatsignales (40) des Funksignals enthalten ist, wobei das MPX Formatsignal ferner ein Pilotsignal (53) zum Anzeigen, dass ein Stereoaudioinhalt vorhanden ist, aufweist.

7. Das Verfahren gemäß irgendeinem der Ansprüche 1 bis 6, wobei das Identifikationssignal von einer hörbaren Amplitude ist.

8. Das Verfahren gemäß irgendeinem der Ansprüche 1 bis 7, wobei das Identifikationssignal ein Festtonsignal (41, 83) ist.

9. Das Verfahren gemäß irgendeinem der Ansprüche 1 bis 8, wobei in Antwort auf eine Änderung der Frequenz des Funksignals (80; 81) die Schritte a), b) und c) wiederholt werden, um den Funkempfänger auf die geänderte Frequenz umzustimmen.

10. Das Verfahren gemäß irgendeinem der Ansprüche 1 bis 9, welches ferner ein Anpassen (54) des Funkempfängers daraufhin aufweist, die Schritte a), b) und c) zu wiederholen, um sich automatisch auf ein Funksignal zu tunen, welches ein Audiosignal aufweist, welches ein weiteres Identifikationssignal hat.

11. Das Verfahren gemäß Anspruch 10, wobei das Anpassen ein Anpassen des Funkempfängers aufweist, sich auf ein Funksignal zu tunen, welches ein Audiosignal aufweist, welches ein besonderes weiteres Identifikationssignal hat.

12. Das Verfahren gemäß irgendeinem der Ansprüche 1 bis 11, wobei die Amplitude des Identifikationssignals (41) moduliert wird (39), Information zu tragen, welche das Audiosignal identifizieren.

13. Ein Funkempfänger (13; 42; 95) zum Tunen auf ein Funksignal (9; 80; 81), welches ein Audiosignal (7; 91) aufweist, wobei das Audiosignal ein eingebettetes Identifikationssignal (41; 83) hat, wobei der Funkempfänger aufweist:
a) einen Tuner (16; 29, 31, 47) zum Tunen auf ein erstes Funksignal;
b) einen Identifikationssignaltester (18; 44, 45, 46) zum Testen des ersten Funksignals auf das Identifikationssignal, und
c) Eine Einstellsteuerung (20; 47) zum automatischen Tunen des Tuners auf nachfolgende Funksignale bis der Identifikationssignaltester anzeigt, dass der Tuner auf das Funksignal getunt ist, welches das Identifikationssignal hat.

14. Ein Radio (105), welches den Funkempfänger (13; 42; 95) gemäß Anspruch 13 aufweist.

15. Einen Sender (78; 85), welcher eingerichtet ist, ein Funksignal (80; 81) zu senden, welches das Audiosignal (49; 89) und das eingebettete Identifikationssignal (41; 83) gemäß irgendeinem der Ansprüche 1 bis 12 aufweist, wobei der Sender aufweist:
einen Identifikationssignaleinbetter (73; 82) zum Einbetten des Identifikationssignals in das Audiosignal;
einen Funksignalgenerator (77; 86) zum Generieren des Funksignals, welches das Audiosignal mit dem eingebetteten Identifikationssignal aufweist.

16. Vorrichtung zum Senden eines Funksignals und Tunen auf das Funksignal, wobei die Vorrichtung den Sender gemäß Anspruch 15 und den Funkempfänger gemäß Anspruch 13 aufweist.

17. Ein Verfahren zum Senden und Tunen auf ein Funksignal (9; 80; 81), wobei das Verfahren aufweist:
Einbetten eines Identifikationssignals (41; 83) in ein Audiosignal (49; 89);
Senden eines Funksignals (9; 80; 81), welches das Audiosignal und das eingebettete Identifikationssignal aufweist;
Tunen eines Funkempfängers (13; 42; 95) auf das Funksignal mittels:
a) Tunen (62; 64) des Funkempfängers auf ein erstes Funksignal;
b) Testen (66) des ersten Funksignals auf das Identifikationssignal;
c) automatisches Wiederholen der Schritte a) und b) für nachfolgende Funksignale bis der Funkempfänger auf das Funksignal getunt ist, welches das Identifikationssignal hat.

## Revendications

1. Procédé de réglage d'un récepteur radio (13 ; 42 ; 95) sur un signal radio (9 ; 80 ; 81) qui comprend un signal audio (7 ; 91), le signal audio ayant un signal d'identification intégré (41 ; 83), le procédé comprenant :
a) le réglage (62, 64) du récepteur radio sur un premier signal radio ;
b) le test (66) du premier signal radio pour le signal d'identification ; et
c) la répétition automatique des étapes a) et b) pour d'autres signaux radio ultérieurs jusqu'à ce que le récepteur radio soit réglé sur le signal radio ayant le signal d'identification.

2. Procédé selon la revendication 1, comprenant en outre le filtrage (48 ; 100) du signal audio dans le récepteur radio pour éliminer le signal d'identification (41 ; 83) et reproduire le signal audio filtré.

3. Procédé selon les revendications 1 ou 2, dans lequel le signal audio comporte une composante de signal monaurale et une composante de signal stéréo, et dans lequel la composante de signal stéréo contient le signal d'identification (41).

4. Procédé selon la revendication 3, dans lequel le procédé comporte l'élimination par filtrage de la composante audio stéréo et la reproduction de la composante de signal monaurale uniquement.

5. Procédé selon la revendication 4, dans lequel la composante de signal stéréo contient des données audio en plus du signal d'identification.

6. Procédé selon l'une quelconque des revendications 3 à 5, dans lequel le signal audio est compris dans un signal de format MPX (40) du signal radio, le format MPX comprenant en outre un signal pilote (53) pour indiquer que ce contenu audio stéréo est présent.

7. Procédé selon l'une quelconque des revendications 1 à 6, dans lequel le signal d'identification est d'amplitude audible.

8. Procédé selon l'une quelconque des revendications 1 à 7, dans lequel le signal d'identification est un signal de tonalité fixe (41, 83).

9. Procédé selon l'une quelconque des revendications 1 à 8, dans lequel, en réponse à une modification de la fréquence du signal radio (80 ; 81), les étapes a) b) et c) sont répétées pour réaccorder le récepteur radio sur la fréquence modifiée.

10. Procédé selon l'une quelconque des revendications 1 à 9, comprenant en outre l'ajustement (54) du récepteur radio pour qu'il répète les étapes a), b) et c) de manière à se régler automatiquement sur un signal radio qui comporte un signal audio ayant un autre signal d'identification.

11. Procédé selon la revendication 10, dans lequel l'ajustement consiste à ajuster le récepteur radio pour qu'il s'accorde sur un signal radio qui comporte un signal audio ayant un autre signal d'identification particulier.

12. Procédé selon l'une quelconque des revendications 1 à 11, dans lequel l'amplitude du signal d'identification (41) est modulée (39) pour porter une information identifiant le signal audio.

13. Récepteur radio (13 ; 42 ; 95) destiné à se régler sur un signal radio (9 ; 80 ; 81) qui comprend un signal audio (7 ; 91), le signal audio ayant un signal d'identification intégré (41 ; 83), le récepteur radio comprenant :
- un dispositif de réglage (16 ; 29, 31, 47) pour s'accorder sur un premier signal radio ;
- un dispositif de test du signal d'identification (14 ; 44, 45, 46) pour tester le premier signal radio pour le signal d'identification ; et
- un dispositif de contrôle de réglage (20 ; 47) pour régler automatiquement le dispositif d'accord sur d'autres signaux radio ultérieurs jusqu'à ce que le dispositif de test du signal d'identification indique que le dispositif d'accord est réglé sur le signal radio qui a le signal d'identification.

14. Radio (105) comprenant le récepteur radio (13 ; 42 ; 95) selon la revendication 13.

15. Emetteur (78 ; 85) agencé de manière à émettre un signal radio (80 ; 81) comprenant le signal audio (49 ; 89) et le signal d'identification intégré (41 ; 83) selon l'une quelconque des revendications 1 à 12, l'émetteur comprenant :
un dispositif d'intégration du signal d'identification (73 ; 82) pour intégrer le signal d'identification dans le signal audio ;
un générateur de signal radio (77 ; 86) pour générer le signal radio comprenant le signal audio avec le signal d'identification intégré.

16. Appareil pour émettre un signal radio et se régler sur le signal radio, l'appareil comprenant l'émetteur de la revendication 15 et le récepteur radio de la revendication 13.

17. Procédé d'émission d'un signal radio et de réglage sur celui-ci (9 ; 80; 81), le procédé comprenant :
- l'intégration d'un signal d'identification (41 ; 83) dans un signal audio (49 ; 89) ;
- l'émission d'un signal radio (9 ; 80 ; 81) qui comprend le signal audio et le signal d'identification intégré ;
- le réglage du récepteur radio (13 ; 42 ; 95) sur le signal radio grâce aux étapes suivantes :
a) le réglage (62, 64) du récepteur radio sur un premier signal radio ;
b) le test (66) du premier signal radio pour le signal d'identification ; et
c) la répétition automatique des étapes a) et b) pour d'autres signaux radio ultérieurs jusqu'à ce que le récepteur radio soit réglé sur le signal radio ayant le signal d'identification.
